# EUROPEAN PATENT APPLICATION

(11) **EP 2 429 055 A2**
(43) Date of publication of application: **14.03.2012**
(21) Application number: 11159908.0
(22) Date of filing: 25.03.2011
(51) Int. Cl.: H02J 7/00

(54) **Time dampened charging indicator**

(30) Priority: 14.09.2010 US 382597 P
(71) Applicant: RESEARCH IN MOTION LIMITED, Waterloo, Ontario N2L 3W8 (CA)
(72) Inventor: Patino, Joseph, Sunrise, FL 33323 (US); Walls, Erik Jayson, Sunrise, FL 33323 (US); Brubacher, Jonathan Quinn, Waterloo Ontario N2L 5R9 (CA)
(74) Representative: Fennell, Gareth Charles

(57) **Abstract**

Systems and methods to determine a power pack charging state. A difference between a first power pack capacity of a power pack at a first time and a second power pack capacity of the power pack at a second time is estimated, where the second time is a time duration after the first time. A determination is made that the charging state is "not charging" if the power pack capacity decreases between the two times. A determination is made that the charging state is "charging" if the power pack capacity increases between the two times. If a change in power pack capacity is not observed between the two times, the power pack charging state of the previous determination is used. Various techniques are used to determine the difference in power pack charging state.

## Description

### FIELD OF THE DISCLOSURE

The present disclosure generally relates to power pack charging circuits and related processing and more particularly to determining a charging state of a power pack.

### BACKGROUND

Electronic devices, such as portable electronic devices, include power packs such as batteries to provide operating power to the device. Devices with power packs also accept power from external supplies to power the electronic device as well as to charge the power pack. The charging of a power pack is sometimes interrupted due to various conditions. For example, power pack charging circuits are able to monitor a temperature of the power pack being charged and discontinue charging the power pack when its temperature becomes too high. In such a case, the charging of the power pack may itself have caused the power pack temperature to increase to the point of triggering the charging circuit to cease charging. Once the charging has stopped, the power pack cools and charging resumes, which can again cause the power pack to heat and trigger the charging to stop due to a high power pack temperature. In another example, a temporarily high electrical current demand of the electronic device may exceed the capacity of the external power supply. In such a case, the external power supply still provides electrical current to the electronic device but the power pack is not being charged since that electrical current from the external power supply is consumed by the circuits of the electronic device. In such a situation, the power pack may also be augmenting the external power supply electrical current to the electronic device. Once the high electrical current demand is reduced, the power pack resumes charging.

Many electronic devices include a user display, such as a light or graphical display icon, that indicates that the device's power pack is charging. In the above described situation of alternating between charging and not charging the electronic device's power pack, the user display will alternate between indicating that the power pack is charging and discharging. Such an alternating display may cause a user to erroneously believe the electronic device's charging circuits are malfunctioning or that the power pack is in need of replacement.

Therefore, the utility of power pack charging indicators of electronic devices is limited by indicating normally occurring frequent alternations between charging and not charging.

### BRIEF DESCRIPTION OF THE DRAWINGS

The accompanying figures where like reference numerals refer to identical or functionally similar elements throughout the separate views, and which together with the detailed description below are incorporated in and form part of the specification, serve to further illustrate various embodiments and to explain various principles and advantages all in accordance with the present disclosure, in which:

FIG. 1 is a device component interconnection diagram according to one example;

FIG. 2 is a first circuit diagram illustrating electrical power components of a portable electronic device illustrated in FIG. 1;

FIG. 3 is a second circuit diagram illustrating electrical power components of an alternative electronic device;

FIG. 4 illustrates a power pack capacity change determination process in accordance with one example;

FIG. 5 illustrates an alternative power pack charging state determination process, in accordance with one example; and

FIG. 6 is a block diagram of an electronic device and associated components in which the systems and methods disclosed herein may be implemented.

### DETAILED DESCRIPTION

As required, detailed embodiments are disclosed herein; however, it is to be understood that the disclosed embodiments are merely examples and that the systems and methods described below can be embodied in various forms. Therefore, specific structural and functional details disclosed herein are not to be interpreted as limiting, but merely as a basis for the claims and as a representative basis for teaching one skilled in the art to variously employ the disclosed subject matter in virtually any appropriately detailed structure and function. Further, the terms and phrases used herein are not intended to be limiting, but rather, to provide an understandable description.

The terms "a" or "an", as used herein, are defined as one or more than one. The term plurality, as used herein, is defined as two or more than two. The term another, as used herein, is defined as at least a second or more. The terms "including" and "having," as used herein, are defined as comprising (i.e., open language). The term "coupled," as used herein, is defined as "connected," although not necessarily directly, and not necessarily mechanically.

In the following discussion, power pack capacity refers to a present energy capacity of a power pack, such as a power pack. For example, power pack capacity may refer to a number of Amp-Hours remaining within a power pack or a percentage of the power pack's total designed capacity when fully charged. Power pack capacity as used below generally refers to a charge level of a power pack or a comparable measure of any suitable power pack.

Described below are systems and methods for determining a power pack charging state for an electronic device. The charging state determined by the following systems and methods include charging states where the power pack, such as a power pack or other rechargeable energy source, is charging or is not charging. This determination is used to control processing within the electronic device, such as controlling a user interface to indicate that the power pack is charging or not charging. An operating mode of an electronic circuit within the electronic device may also be changed in response to the power pack charging state, such as placing the electronic device into a lower power consumption mode when the power pack is not charging when the power pack capacity of the power pack is below a threshold.

In one example, charging state is determined based upon an determined change in power pack capacity. In one example, a power pack capacity change is based upon estimates of differences in power pack capacity differences between a first time and a second time. The second time occurs after a time duration elapses after the first time. A determination is made that the power pack is charging if the power pack capacity increases between the first time and the second time. A determination is made that the power pack is not charging if the power pack capacity decreases between the first time and the second time. If it is determined that the power pack capacity has not changed, the determined charging state remains unchanged from the charging state that was previously determined based on the last estimated change in power pack capacity, Various techniques are used to determine changes in power pack capacity or the difference in power pack capacities between the first time and the second time.

In one example, the difference in power pack capacity is determined by subtracting an estimated power pack capacity determined at the first time from an estimated power pack capacity determined at the second time. The power pack capacity is able to be determined by various techniques, such as by reading data from a continuously operating Coulomb counting power pack capacity meter component or a measured voltage of the power pack. The difference in power pack capacity is also able to be estimated by, for example, an estimate of net charging current delivered to the power pack during the time duration. Net charging current is able to be estimated by estimating an amount of electrical current charging the power pack and subtracting therefrom an estimate of an amount of electrical current leaving the power pack. In one example, the amount of electrical current charging the power pack is estimated by determining an amount of time, during the time duration between the first time and the second time, that the power pack is charging and multiplying that amount of time by an estimate of an amount of electrical current being delivered during charging. The amount of electrical current leaving the power pack is estimated by determining an amount of time during the time duration between the first time and the second time that the power pack is not charging and multiplying that time by an estimate of electrical current drain from the power pack. Based upon which of these electrical current estimates is greater, a determination is made if a net amount of electrical current was delivered to charge the power pack or a net amount of electrical current was drained from the power pack during the time duration. A determination is made that the power pack is charging if a net amount of electrical current is delivered to the power pack during the time duration. A determination is made that the power pack is not charging if a net amount of electrical current is drained from the power pack during the time duration.

The time duration between the first time and the second time is able to be adjusted based upon, for example, the determined power pack capacity of the power pack. In one case, the time duration is one minute when the power pack capacity is greater than or equal to ten percent (10%), and is thirty seconds when the power pack capacity is below ten percent (10%).

Once a determination is made that the power pack is not charging, the operation of an electronic device powered by that power pack may be modified to conserve energy. For example, an operating mode of the electronic device may be changed in response to a low power pack capacity and a determination that the power pack is not charging. In a configuration where the operating mode is modified to reduce power consumption when the power pack capacity is reduced below a threshold, the threshold may be raised if it is determined that the power pack is not charging or lowered if it is determined that the power pack is charging.

As an alternative to estimating power pack capacity at different times, the processing of one example receives an indication from a power pack charge monitor that the power pack capacity of a device's power pack has changed. In response to receiving such an indication, the processing determines a direction of change in the reported power pack capacity. The direction of change is able to be an increase or a decrease in power pack capacity. Based on the direction of change of the power pack capacity, a charging indicator is displayed or a "blank" charging indicator is displayed. Displaying a blank charging indictor is performed in one example by not displaying a charging indicator on a graphical display.

The described systems and methods provide a more accurate determination of a charging state of a power pack by monitoring changes in power pack capacity over a time duration. Such processing "dampens" the reporting of charging state changes by not relying upon instantaneous charging states but rather monitors the truly important quantity of power pack capacity changes over a time duration. In the described systems and methods, short term changes in charging state, such as induced by power pack heating during charging, are not reflected in the determination of charging state but rather the net increase or decrease in power pack capacity over a sufficiently long time duration is monitored and used as the basis for determining charging state of the power pack.

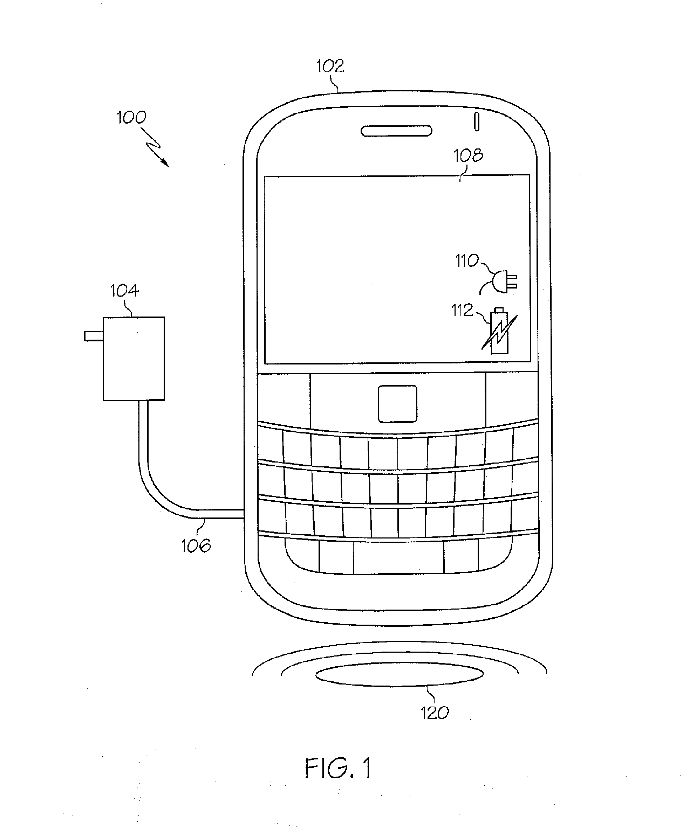

FIG. 1 is a device component interconnection diagram 100 according to one example. The interconnection diagram 100 shows a portable electronic device 102, such as a Personal Digital Assistant (PDA), a smart-phone, a cellular telephone, or any other type of portable electronic device. The portable electronic device 102 receives external power from an external power source 104 power through one or more interfaces, such as a DC power connection 106.

As an alternative to receiving power through a DC power connection 106, external power is also able to be provided through a wireless charging base 120. In one example, a wireless charging base 120 wirelessly provides external power to the portable electronic device 102 through, for example, inductive coupling or other suitable techniques.

The portable electronic device 102 has a display 108. The display 108 depicted in FIG. 1 is an alpha numeric display capable of displaying various icons as indicators of a corresponding status or event within the portable electronic device 102.

The illustrated display 108 displays an external power connected icon 110 and a power pack charging icon 112. In various examples, the external power connected icon 110 is displayed whenever an external power source 104 is connected to the DC power connection 106 or a wireless charging base 120 is detected as providing external power to the portable electronic device 102. The power pack charging icon 112 is displayed whenever a determination is made that the power pack of the portable electronic device is charging, as is described in further detail below.

Further examples of user interfaces are able to present indicators to a user that a determination is made that the power pack of a device is charging. For example, an indictor light or other indicator is able to be used alone or in conjunction with a display 108 to indicate charging state.

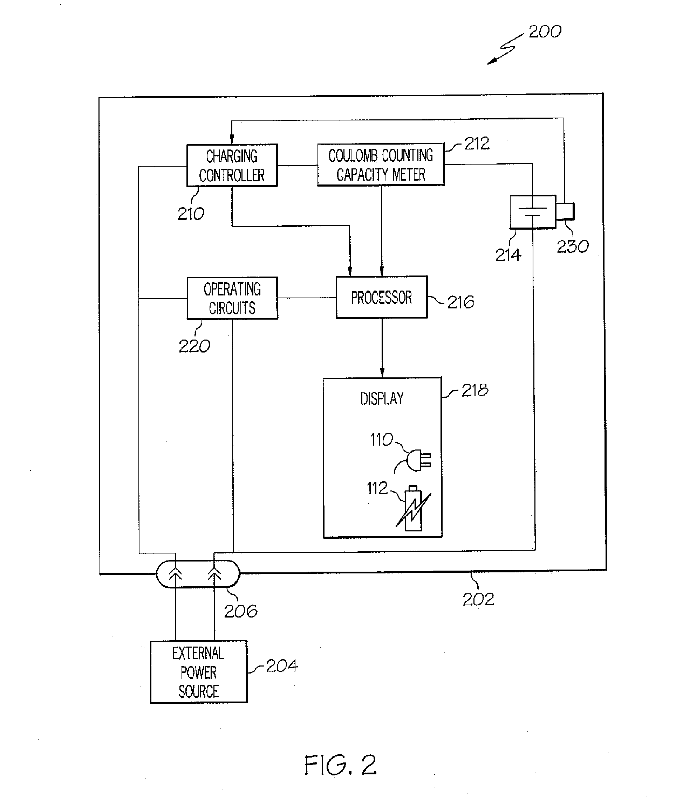

FIG. 2 is a first circuit diagram 200 illustrating electrical power components of an electronic device. The first circuit diagram 200 illustrates a portion of an example of circuits included in the portable electronic device 102 discussed above. In the first circuit diagram 200, an external power source 204 is connected to an example electronic device 202 through an external power connection 206.

The example electronic device 202 includes operating circuits 220 that are electronic circuits that perform, for example, processing associated with a cellular telephone, a smart phone, a personal digital assistant (PDA), or some or all of any processing required by the example electronic device 202. In one example, the operating circuits 220 is an electronic circuit that is able to be placed into one or more operating modes, including one or more modes that consume less electrical current.

The example electronic device 202 further includes a power pack that in one example consists of a power pack 214. Further examples include any suitable power pack. The power pack 214 is used as a power source when, for example, the external power source 204 is not connected to the example electronic device 202. Power pack 214 is also able to augment the power provided to the operating circuits 220 when the external power source 204 is connected to the example electronic device 202 but when the operating circuits 220 are operating in a mode that has an electrical current consumption that is greater than the electrical current supply capacity value of the external power source 204.

The example electronic device 202 also includes a charging controller 210 that controls charging the power pack 214 when the external power source 204 is connected to the external power connector 206. The charging controller 210 modifies an amount of electrical current provided to the power pack 214 based upon a determined present power pack capacity of the power pack 214 and other factors. The power pack 214 of one example includes a temperature monitor 230 that determines the temperature of the power pack 214 and reports that temperature to the charging controller 210. The charging controller 210 in one example stops charging the power pack 214 when the temperature of the power pack exceeds a threshold. Once the temperature of the power pack goes below that threshold, the charging circuit resumes charging the power pack 214.

The present power pack capacity of the power pack 214 is determined by a Coulomb counting capacity meter 212. The Coulomb counting capacity meter 212 is a power pack capacity monitor that is a dedicated circuit configured to continually monitor the amount of electrical current being delivered to or taken from the power pack 214. The Coulomb counting capacity meter 212 measures a net amount of charging current, or Coulombs, that is delivered to the power pack 214. Based upon these measurements, the Coulomb counting capacity meter 212 of one example is able to output a series of power pack capacity monitoring values in the form of present power pack capacity estimates. The illustrated example electronic device 202 depicts the Coulomb counting capacity meter 212 connected to a positive side of the power pack 214. Further examples are able to include a Coulomb counting capacity meter 212 that is alternatively connected to the negative side of the power pack 214.

In one example, the Coulomb counting capacity meter 212 determines changes in power pack capacity of the power pack 214 and provides an indication as an output that the power pack capacity of the power pack 214 has changed. This indication of a change in power pack capacity is also able to be accompanied with an indication of an estimate of the present power pack capacity. A processor is able to respond to these indicated changes of power pack capacity by determining a charging state based upon a direction of indicted power pack capacity changes.

Processor 216 performs various operations to control the example electronic device 202. The processor 216 drives a display 218 to present information to a user of the example electronic device 202. The display 218 of one example includes an external power connected icon 110 and a power pack charging icon 112. The processor 216 receives a present power pack capacity value estimate from the Coulomb counting capacity meter 212. The processor 216 determines, based upon information provided by the charging controller 210 and the Coulomb counting capacity meter 212, the charging state of the power pack 214. The processor 216 also determines based upon information received from the charging controller 210 if an external power source 204 is connected to the example electronic device 202.

In a case where the charging controller 210 is alternating between charging the power pack 214 and not charging the power pack 214, the processor determines, by processing described in further detail below, the net charging current and electrical current drain over a time duration. In response to this determination, the processor 216 presents or does not display the power pack charging icon 112 on the display 218.

Based on the determined charging state of the power pack 214, and the present capacity of the power pack 214, the processor 216 of one example is able to command the operating circuits 220 to enter into a lower electrical current consumption mode. Commanding the operating circuit 220 into a lower electrical current consumption mode when the charging controller 210 is not providing a net charge to the power pack 214 operates to conserve power pack capacity and extend the operational time for the example electronic device 202.

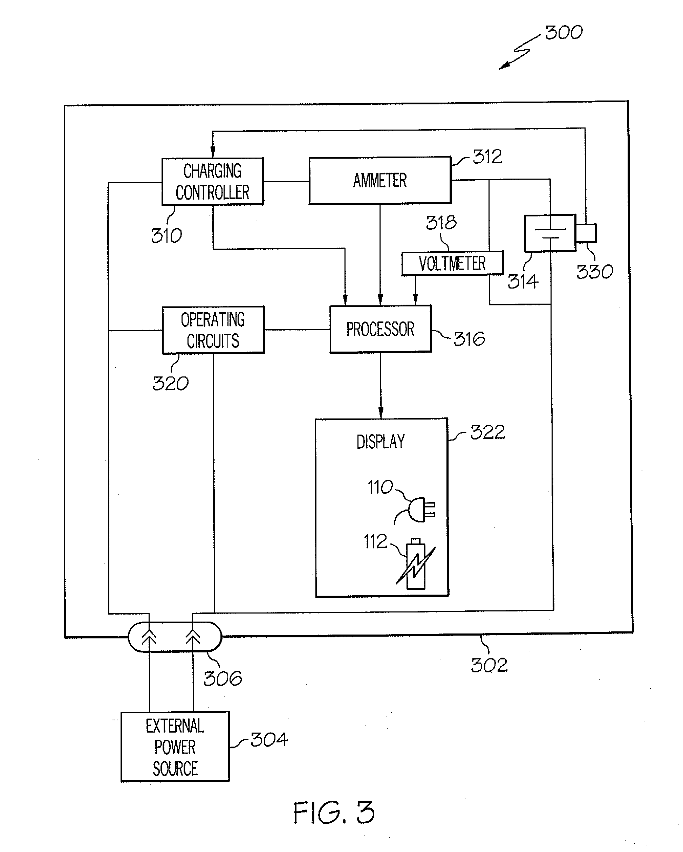

FIG. 3 is a second circuit diagram 300 illustrating electrical power components of an alternative electronic device 302. The alternative electronic device 302 shares a similar architecture with the example electronic device 202, described above. The alternative electronic device 302 is connected to an external power source 304 through a suitable interface, such as an external power connection 306 or a wireless charging base 120. The alternative electronic device 302 also has operational circuits 320 that are powered by a power pack 314 when the external power source 304 is not connected. A charging controller 310 controls charging of the power pack 314. The temperature of the power pack 314 is monitored by a temperature monitor 330 that reports power pack temperature to the charging controller 310 in order to inhibit charging when the power pack becomes too hot.

The alternative electronic device 302 has a display 322 that is able to display an external power connected icon 110 and a power pack charging icon 112. The display 322 is controlled by a processor 316 that determines if an external power source 304 is connected and also determines if the power pack 314 is charging. Based on those determinations, the processor 316 causes one or more of the external power connected icon 110 and the power pack charging icon 112 to be displayed.

The processor 316 of the alternative electronic device 302 utilizes alternative techniques to determine a present charging state for a power pack, such as power pack 314. Charging state is determined in some examples by monitoring changes in power pack capacity during a time duration and to thereby determine if the power pack 314 is charging. Charging state is also able to be determined by monitoring net electrical current flows into and out of the power pack 314. Additionally, charging state is able to be determined by monitoring changes in power pack output voltage at the output of the power pack 314. The illustrated alternative electronic device 302 includes both an ammeter 312 in series with the power pack 314 and a voltmeter 318 in parallel with the power pack 314. Ammeter 312 is a power pack current meter that is able to measure net electrical current flow into and out of the power pack 314. Voltmeter 318 is able to determine power pack output voltage values at separate times and provide those measured power pack output voltages to a processor to support determining the charging state of the power pack 314.

The illustrated alternative electronic device 302 depicts the ammeter 312 as connected to a positive side of the power pack 314. Further examples are able to include an ammeter 312 that is alternatively connected to the negative side of the power pack 314. Variations of the alternative electronic device 302 are able to include only one of the ammeter 312 and voltmeter 318, Further variations are able to not include either an ammeter 312 or a voltmeter 318.

The processor 316 of the alternative electronic device 302 monitors power pack capacity monitoring values provided by the ammeter 312, in the form of a series of measured electrical current into or out of the power pack 314, to determine the net amount of electrical current flowing into and out of the power pack 314. Summing the electrical current flow over the time duration, which can be either a positive value to indicate electrical current flowing into the power pack 314 or a negative value to indicate electrical current flowing out of the power pack 314, yields a net charging current value over the time duration for the power pack 314. The net charging current value for the power pack 314 over a time duration is able to be used to determine if the power pack 314 is charging, If the net charging current being delivered to the power pack 314 is greater than zero during a time duration, it is assumed that the power pack capacity of the power pack 314 during the time duration increases. The processor 316 of one example determines that the power pack is charging if the net charging current being delivered to the power pack 314 is greater than zero during the time duration and causes the power pack charging icon 112 to be displayed. If the net charging current being delivered to the power pack 314 is less than zero during the time duration, then more electrical current is drained from the power pack 314 than is delivered for charging the power pack 314 and the power pack capacity of the power pack 314 decreases during the time duration. In the case of a net charging current delivered to the power pack 314 that is less than zero, the processor 316 of one example determines that the power pack is not charging and does not display the power pack charging icon 112 on the display 322.

The voltmeter 318 monitors the power pack output voltage, which is the output voltage produced by the power pack 314, to estimate the present power pack capacity of the power pack 314. An increase in power pack output voltage over a time duration indicates an increase in the present power pack capacity of the power pack 314 during the time duration. A decrease in power pack output voltage over the time duration indicates a decrease in the present power pack capacity of the power pack 314 during the time duration. The voltmeter 318 provides a series of power pack capacity monitoring values in the form of measured power pack output voltages to the processor 316.

The processor 316 of the alternative electronic device 302 also receives an indication from the charging controller 310 that charging current is being provided to the power pack 314. In one example of a configuration that does not include either an ammeter, voltmeter, or other power pack capacity measurement device, the processor is able to estimate a net charging current delivered to the power pack 314 by determining an amount of time during a time duration that charging current is being delivered to the power pack 314 and also determining an amount of time during that time duration during which charging current is not being delivered to the power pack 314. Charging current is assumed to not be delivered to the power pack 314 when the charging controller indicates that it is not charging the power pack 314.

The processor 316 in an example circuit without an ammeter 312, a voltmeter 318, or other power pack capacity monitoring devices, is able estimate the net charging current delivered by the power pack 314 based upon stored estimates of charging current supplied during charging times and electrical current drain during non-charging times. These estimates are able to be determined based upon circuit analysis or empirical measurements. Electrical current delivered to the power pack is estimated by multiplying the estimated charging current by the amount of time that charging current is being delivered to the power pack 314. Electrical current drain is estimated by multiplying estimated electrical current drain by the amount of time during which charging current is not being delivered to the power pack 314. The net charging current is then estimated by subtracting the estimated electrical current drain from the estimated charging current delivered to the power pack 314. These estimates of charging current and electrical current drain are able to be enhanced by status information received from the charging controller 310 and the operating circuits 320.

The processor 316 of the alternative electronic device 302 receives an indication from the charging controller 310 if power pack charging is suspended because of the temperature of the power pack exceeds a threshold. In some examples, the processing to determine the charging state of the power pack 314 is modified in response to determining that charging is not inhibited due to the temperature of the power pack exceeding a threshold within the time duration. In such a configuration, when the temperature of the power pack remains below the threshold that would inhibit charging, the processor 316 receives a status from the charging controller 310 as to whether the charging controller is charging the power pack 314, and the processor simply uses that indication from the charging controller 310 to determine whether or not to display the power pack charging icon 112 on the display 322. In conditions during which the charging controller reports that charging has been inhibited due to the power pack's temperature, the processor 316 in one example determines the change in power pack capacity during time duration around the time of inhibited charging to control the display of the power pack charging icon 112.

It is clear that examples of the described systems and methods are able to determine charging state by measuring net current flowing into and out of the power pack, such as power pack 314. Further examples are able to measure changes in output voltage of the power pack to determine charging state. For example, processor 326 is able to receive a first power pack output voltage value measured at a first time and a second power pack output voltage value measured at a second time. The processor is then able to determine a difference between these two power pack output voltage values in order to determine the charging state of the power pack. An increase in voltage between these two times indicates that the power pack is charging. A decrease in voltage between these two times indicates that the power pack is not charging. Such examples are not required to explicitly determine the power pack capacity of the power pack but are able to simply determine charging state based on net current values and changes in power pack output voltage values between two times.

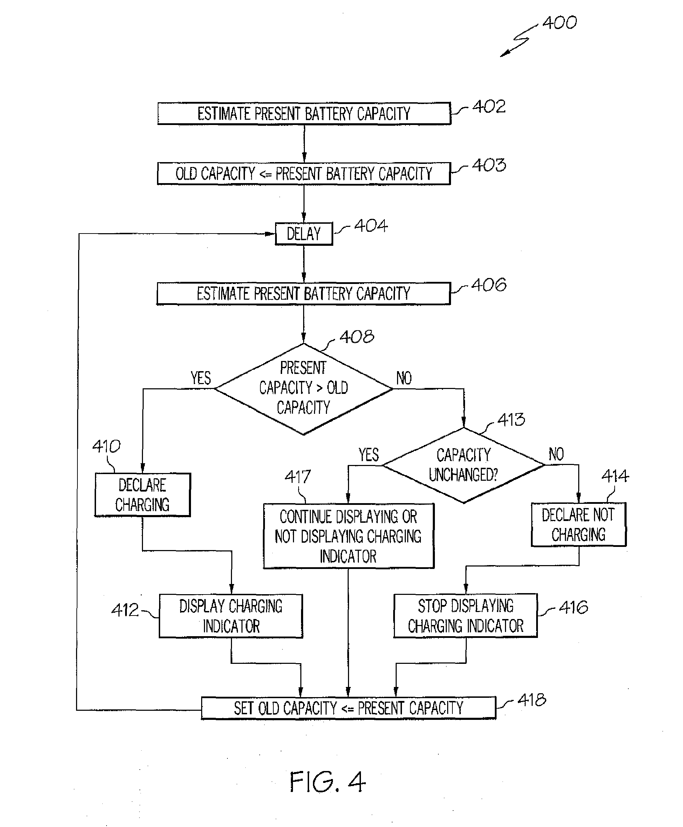

FIG. 4 illustrates a power pack capacity change determination process 400 in accordance with one example. The power pack capacity change determination process 400 is performed by the processor 216 of the example electronic device 202 described above. The power pack capacity change determination process 400 is used to determine if a power pack charging icon 112 should be displayed on a device to provide an accurate indication that the device's power pack is charging.

The power pack capacity change determination process 400 begins by estimating, at 402, the present power pack capacity of a device's power pack. As discussed above, the present power pack capacity of the devices power pack is able to be determined by data received from a Coulomb counting capacity meter, by integrating measured electrical current into and out of the power pack, or by measuring a present power pack output voltage. Further examples are able to use any suitable technique to determine or estimate the present power pack capacity of the device's power pack. A program storage element named OLD CAPACITY is set, at 403, to store the value of the estimated present power pack capacity of the device's power pack.

The power pack capacity change determination process 400 continues by delaying, at 404, for a time duration. The power pack capacity change determination process 400 is used in one example to control the display of a power pack charging indicator. The power pack capacity change determination process 400 operates to reduce a changing state of the power pack charging indicator when power pack charging is periodically interrupted due to, for example, power pack over-temperature conditions. The time duration of the delay is able to be selected based upon an observed or estimated time duration over which power pack charging will be interrupted due to such recurring conditions. In one example, the time duration is selected to be one minute when the power pack is estimated to have greater than ten percent (10%) remaining power pack capacity, and thirty seconds when the power pack is estimated to have less than ten percent (10%) power pack capacity. The time duration of the delay at 404 is able to be selected to set a minimum amount of time between changes of state of the power pack charging icon 112.

The power pack capacity change determination process 400 continues by estimating, at 406, the present power pack capacity of a device's power pack after the above delay time duration. The estimated present power pack capacity of the device's power pack is able to be determined as described above at 402, or by an alternative technique.

The power pack capacity change determination process 400 continues by determining, at 408, if the present power pack capacity of the power pack after the delay is greater than the OLD CAPACITY value that was measured before the delay at 404. If the present power pack capacity is determined to be greater than the OLD CAPACITY, a change in power pack capacity is determined and the direction of change of the power pack, or power pack, capacity is determined to be is increasing. Because the direction of change is determined to be increasing, the processing declares, at 410, that the power pack is charging and displays, at 412, a respective charging indicator, such as the power pack charging icon 112, that reflects the direction of change of the power pack capacity.

If the present power pack capacity is not determined to be greater than the OLD CAPACITY, the processing determines, at 413, if the estimated present power pack capacity is unchanged from the OLD CAPACITY. If the power pack capacity is not determined to be unchanged, a change in power pack capacity is determined and the direction of change of power pack, or power pack, capacity is decreasing. Because the direction of change is determined to be decreasing, the processing declares, at 414, that the power pack is not charging and stops, at 416, displaying the charging indicator. By stopping the display of the charging indicator, the device displays a blank charging indicator that is a charging indicator that reflects the direction of change of the power pack capacity.

If the power pack capacity is determined to be unchanged, the process continues, at 417, displaying or not displaying the charging indicator, as was last performed at either 412 or 416. In one example, a determination that the estimated power pack capacity of the power pack is unchanged causes the processing to not change its declaration of charging state. When the declared charging state is unchanged, previously initiated actions, such as displaying or not displaying a charging indicator on a user display or changing a circuit's operating mode to reduce energy consumption, is continued. The charging state declared by the above described processing is used as a currently determined charging state for other processing dependent on the charging state.

The process continues by setting, at 418, the OLD CAPACITY storage location to the value of the present power pack capacity value estimated at 406. The process then returns to delay, at 404, as described above.

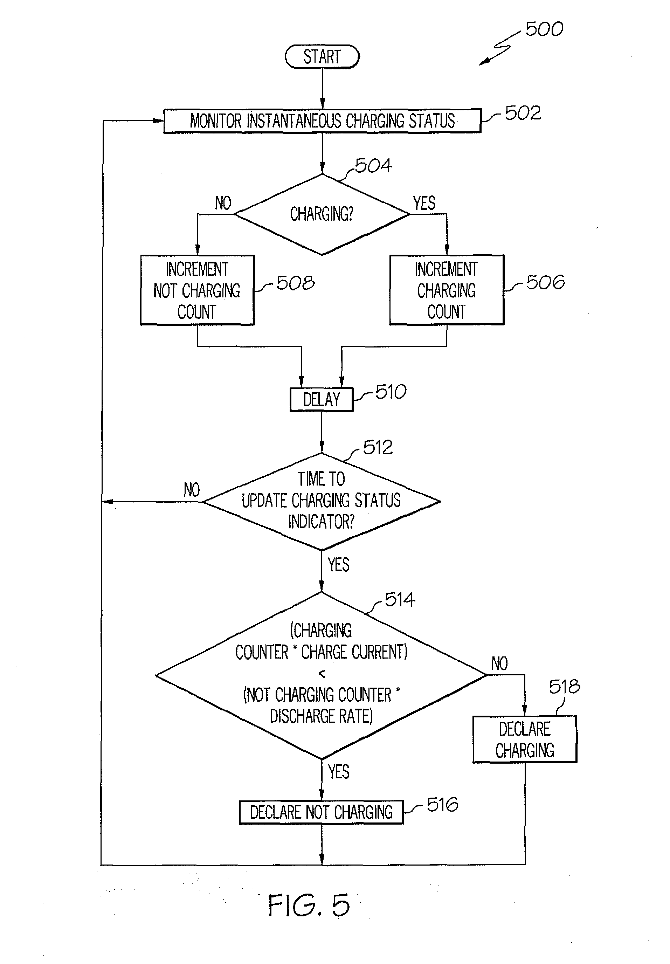

FIG. 5 illustrates an alternative power pack charging state determination process 500, in accordance with one example. The alternative power pack charging state determination process 500 estimates net charging current delivered to a power pack of an electronic device during a time duration to estimate a change in power pack capacity during that time duration. The alternative power pack charging state determination process 500 determines the charging state of the power pack based upon the estimated net charging current delivered to the power pack. The estimated net charging current delivered to the power pack is an estimate of the charging current delivered to the power pack during a time duration where that delivered charging current is reduced by an amount of electrical current drained from the power pack during that time duration.

The alternative power pack charging state determination process 500 estimates net charging current delivered to the power pack by monitoring charging indications that are reported by a power pack charging controller, such as charging controller 210. Charging indications reported by a charging controller indicate that the charging controller is providing charging current to the power pack to charge that power pack. The alternative power pack charging state determination process 500 estimates an amount of charging current delivered to the power pack during a portion of a time duration that the charging controller indicates it is charging the power pack. This estimated amount of electrical current delivered to the power pack increases the net charging current delivered to the power pack.

If the charging controller halts charging due to, for example, the power pack's temperature exceeding a threshold, the alternative power pack charging state determination process 500 assumes that the electronic device is draining another estimated amount of electrical current from the power pack for the time that the charging controller is not charging the power pack. The estimated amount of electrical current drained during the portion of the time duration that the charging controller is not charging the power pack is used to reduce the net charging current delivered to the power pack.

The net charging current delivered to the power pack during a time duration as estimated by the alternative power pack charging state determination process 500 is used to estimate whether there is an increase or a decrease in power pack capacity over that time duration. In one example, the alternative power pack charging state determination process 500 is performed by a processor within the device, such as processor 316 described above.

The alternative power pack charging state determination process 500 begins by monitoring, at 502, an instantaneous power pack charging state. The instantaneous power pack charging state is reported by the charging controller 310. The alternative power pack charging state determination process 500 continues by determining, at 504, if the power pack charging state is "charging." If the charging state is "charging," the process increments, at 508, a CHARGING count. If the charging state is not "charging, the process increments a NOT CHARGING count at 506.

The alternative power pack charging state determination process 500 continues by delaying at 510. The duration of the delay performed at this stage of processing affects the accuracy of the estimate of net charging current delivered to or drained from the power pack. Shorter delays provide greater accuracy but also increase processing resource utilization.

The alternative power pack charging state determination process 500 then determines, at 512, if it is time to update the charging state indicator displayed by the electronic device. As described above for the power pack capacity change determination process 400, the time duration between updates of the charging state indicator is able to be selected based upon an observed or estimated time duration over which power pack charging will be interrupted due to such recurring conditions. For example, the time duration can be selected to be one minute when the power pack is estimated to have greater than ten percent (10%) remaining power pack capacity, and thirty seconds when the power pack is estimated to have less than ten percent (10%) power pack capacity.

If it is determined that it is not time to update the charging state indicator, the process returns to monitoring, at 502, the instantaneous charging state as described above. If it is determined that it is time to update the charging state indicator, the process determines, at 514, if the product of the charging counter and the estimated charging rate is less than the product of the not charging count and an estimated discharging rate. The estimated discharging rate is able to be based upon, for example, an operating mode of electronics within the electronic device performing the alternative power pack charging state determination process 500. Operating modes are able to be determined by a processor that is executing the alternative power pack charging state determination process 500. Such a processor may, for example, query operating circuits to determine an operating mode and based upon the reported operating mode, retrieve a stored electrical current consumption value for that operating mode. The stored electrical current values may be determined by design analyses or measurements made on example hardware.

If it is determined that the product of the charging counter and the estimated charging rate is less than the product of the not charging count and an estimated discharging rate, the process declares, at 516, that the power pack is not charging. If it is determined that the product of the charging counter and the estimated charging rate is not less than the product of the not charging count and an estimated discharging rate, the process declares, at 518, that the power pack is charging. These declarations are the determination of the power pack charging state by the alternative power pack charging state determination process 500. This determination is able to be presented by, for example, an inter-process communications within a processor. The declaration that the power pack is charging or not charging is able to be used to control the display of a power pack charging indicator by the electronic device. The process then returns to monitoring, at 502, the instantaneous charging state, as described above.

As an alternative to the periodic monitoring of instantaneous power pack charging state described above, an further alternative example includes a processor configured to receive a processing interrupt signal that indicates when the power pack charging state changes. In the case of receiving a processing interrupt indicating charging state changes, the processor assumes that the instantaneous charging state remains unchanged during time durations between the processing interrupts. The processor reads a time value from a real time clock to determine a period of time since the last processing interrupt indicating a power pack charging state change and uses that determined period of time as the period of time that the previously reported instantaneous power pack charging state was in effect. The processing of such an example multiplies the determined time of charging by an estimated charging current and multiplies the determined time of not charging by an estimated amount of electrical current that was drained from the power pack to determine a net charging current delivered to the power pack. A comparison similar to that described above at 514 is then performed and similar declarations are subsequently made.

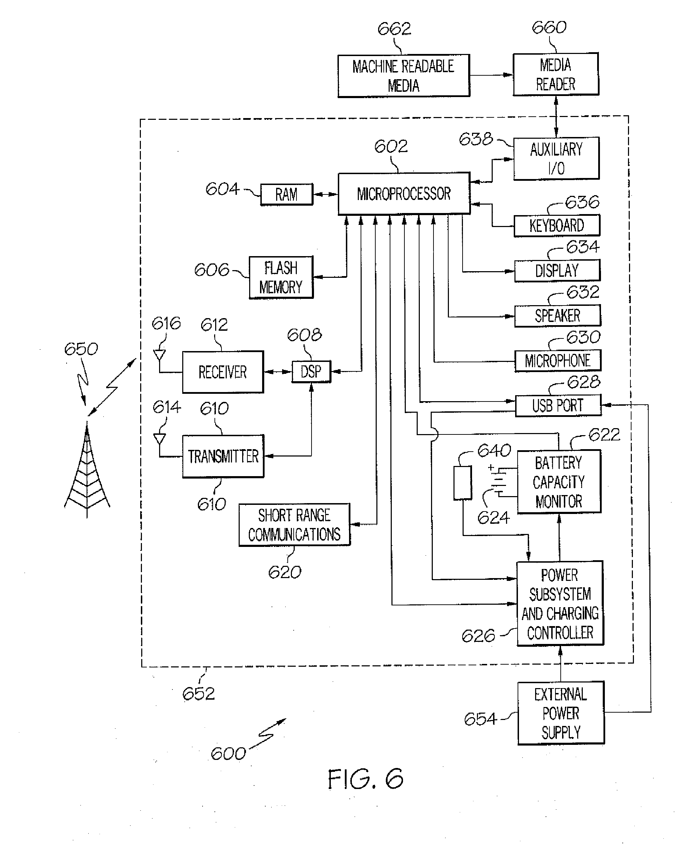

FIG. 6 is a block diagram of an electronic device and associated components 600 in which the systems and methods disclosed herein may be implemented. In this example, an electronic device 652 is a wireless two-way communication device with voice and data communication capabilities. Such electronic devices communicate with a wireless voice or data network 650 using a suitable wireless communications protocol. Wireless voice communications are performed using either an analog or digital wireless communication channel. Data communications allow the electronic device 652 to communicate with other computer systems via the Internet. Examples of electronic devices that are able to incorporate the above described systems and methods include, for example, a data messaging device, a two-way pager, a cellular telephone with data messaging capabilities, a wireless Internet appliance or a data communication device that may or may not include telephony capabilities.

The illustrated electronic device 652 is an example electronic device that includes two-way wireless communications functions. Such electronic devices incorporate communication subsystem elements such as a wireless transmitter 610, a wireless receiver 612, and associated components such as one or more antenna elements 614 and 616. A digital signal processor (DSP) 608 performs processing to extract data from received wireless signals and to generate signals to be transmitted. The particular design of the communication subsystem is dependent upon the communication network and associated wireless communications protocols with which the device is intended to operate.

The electronic device 652 includes a microprocessor 602 that controls the overall operation of the electronic device 652. The microprocessor 602 interacts with the above described communications subsystem elements and also interacts with other device subsystems such as flash memory 606, random access memory (RAM) 604, auxiliary input/output (I/O) device 638, USB Port 628, display 634, keyboard 636, speaker 632, microphone 630, a short-range communications subsystem 620, a power pack capacity monitor 622, a power subsystem and charging controller 626, and any other device subsystems.

A power pack 624 is connected to a power pack capacity monitor 622 and a power subsystem and charging controller 626 as is described in detail above. The power pack 624 provides power to the circuits of the electronic device 652. The power subsystem and charging controller 626 includes power distribution circuitry for providing power to the electronic device 652 and also contains power pack charging controller circuitry to manage recharging the power pack 624. A power pack temperature monitor 640 monitors the temperature of the power pack 624 and reports the temperature to the power subsystem and charging controller 626. The power subsystem and charging controller 626 halts charging when the power pack temperature exceeds a threshold. The power subsystem and charging controller 626 and associated components is described above in further detail with regards to FIGs. 2 and 3.

The microprocessor 602 monitors the status and indications produced by the power pack capacity monitor 622 and the power subsystem and charging controller 626 to perform the processing described above with regards to FIGs. 4 and 5. The power subsystem and charging controller 626 includes a power pack monitoring circuit that is operable to provide a status of one or more power pack status indicators, such as remaining power pack capacity, temperature, voltage, electrical current consumption, and the like, to various components of the electronic device 652.

The USB port 628 provides data communication between the electronic device 652 and one or more external devices. Data communication through USB port 628 enables a user to set preferences through the external device or through a software application and extends the capabilities of the device by enabling information or software exchange through direct connections between the electronic device 652 and external data sources rather than through a wireless data communication network.

Operating system software used by the microprocessor 602 is stored in flash memory 606. Further examples are able to use a power pack backed-up RAM or other non-volatile storage data elements to store operating systems, other executable programs, or both. The operating system software, device application software, or parts thereof, are able to be temporarily loaded into volatile data storage such as RAM 604. Data received via wireless communication signals or through wired communications are also able to be stored to RAM 604. As an example, a computer executable program configured to perform the power pack capacity change determination process 400 and the alternative power pack charging state determination process 500, described above, is included in a software module stored in flash memory 606.

The microprocessor 602, in addition to its operating system functions, is able to execute software applications on the electronic device 652. A predetermined set of applications that control basic device operations, including at least data and voice communication applications, is able to be installed on the electronic device 652 during manufacture. Examples of applications that are able to be loaded onto the device may be a personal information manager (PIM) application having the ability to organize and manage data items relating to the device user, such as, but not limited to, e-mail, calendar events, voice mails, appointments, and task items.

Further applications may also be loaded onto the electronic device 652 through, for example, the wireless network 650, an auxiliary I/O device 638, USB port 628, short-range communications subsystem 620, or any combination of these interfaces. Such applications are then able to be installed by a user in the RAM 604 or a non-volatile store for execution by the microprocessor 602.

In a data communication mode, a received signal such as a text message or web page download is processed by the communication subsystem, including wireless receiver 612 and wireless transmitter 610, and communicated data is provided the microprocessor 602, which is able to further process the received data for output to the display 634, or alternatively, to an auxiliary I/O device 638 or the USB port 628. A user of the electronic device 652 may also compose data items, such as e-mail messages, using the keyboard 636, which is able to include a complete alphanumeric keyboard or a telephone-type keypad, in conjunction with the display 634 and possibly an auxiliary I/O device 638. Such composed items are then able to be transmitted over a communication network through the communication subsystem.

For voice communications, overall operation of the electronic device 652 is substantially similar, except that received signals are generally provided to a speaker 632 and signals for transmission are generally produced by a microphone 630. Alternative voice or audio I/O subsystems, such as a voice message recording subsystem, may also be implemented on the electronic device 652. Although voice or audio signal output is generally accomplished primarily through the speaker 632, the display 634 may also be used to provide an indication of the identity of a calling party, the duration of a voice call, or other voice call related information, for example.

Depending on conditions or statuses of the electronic device 652, one or more particular functions associated with a subsystem circuit may be disabled, or an entire subsystem circuit may be disabled. For example, if the power pack temperature is high, then voice functions may be disabled, but data communications, such as e-mail, may still be enabled over the communication subsystem.

A short-range communications subsystem 620 is a further optional component which may provide for communication between the electronic device 652 and different systems or devices, which need not necessarily be similar devices. For example, the short-range communications subsystem 620 may include an infrared device and associated circuits and components or a Radio Frequency based communication module such as one supporting Bluetooth^{®} communications, to provide for communication with similarly-enabled systems and devices.

A media reader 660 is able to be connected to an auxiliary I/O device 638 to allow, for example, loading computer readable program code of a computer program product into the electronic device 652 for storage into flash memory 606. In one example, computer readable program code includes instructions for performing the power pack capacity change determination process 400 or the alternative power pack charging state determination process 500, described above. One example of a media reader 660 is an optical drive such as a CD/DVD drive, which may be used to store data to and read data from a computer readable medium or storage product such as computer readable storage media 662. Examples of suitable computer readable storage media include optical storage media such as a CD or DVD, magnetic media, or any other suitable data storage device. Media reader 660 is alternatively able to be connected to the electronic device through the USB port 628 or computer readable program code is alternatively able to be provided to the electronic device 652 through the wireless network 650.

Information Processing System

The present subject matter can be realized in hardware, software, or a combination of hardware and software. A system can be realized in a centralized fashion in one computer system, or in a distributed fashion where different elements are spread across several interconnected computer systems. Any kind of computer system - or other apparatus adapted for carrying out the methods described herein - is suitable. A typical combination of hardware and software could be a general purpose computer system with a computer program that, when being loaded and executed, controls the computer system such that it carries out the methods described herein.

The present subject matter can also be embedded in a computer program product, which comprises all the features enabling the implementation of the methods described herein, and which - when loaded in a computer system - is able to carry out these methods. Computer program in the present context means any expression, in any language, code or notation, of a set of instructions intended to cause a system having an information processing capability to perform a particular function either directly or after either or both of the following a) conversion to another language, code or, notation; and b) reproduction in a different material form.

Each computer system may include, inter alia, one or more computers and at least a computer readable medium allowing a computer to read data, instructions, messages or message packets, and other computer readable information from the computer readable medium. The computer readable medium may include computer readable storage medium embodying non-volatile memory, such as read-only memory (ROM), flash memory, disk drive memory, CD-ROM, and other permanent storage. Additionally, a computer medium may include volatile storage such as RAM, buffers, cache memory, and network circuits. Furthermore, the computer readable medium may comprise computer readable information in a transitory state medium such as a network link and/or a network interface, including a wired network or a wireless network, that allow a computer to read such computer readable information.

Non-Limiting Examples

Although specific embodiments of the subject matter have been disclosed, those having ordinary skill in the art will understand that changes can be made to the specific embodiments without departing from the spirit and scope of the disclosed subject matter. The scope of the disclosure is not to be restricted, therefore, to the specific embodiments, and it is intended that the appended claims cover any and all such applications, modifications, and embodiments within the scope of the present disclosure.

## Claims

1. A method for determining a charging state, the method comprising:
estimating (402, 403, 404, 406) a difference between a first power pack capacity of a power pack at a first time and a second power pack capacity of the power pack at a second time, the second time being a time duration after the first time;
determining (408), based upon the difference, a direction of change of power pack capacity of the power pack; and
displaying (412, 416), in response to estimating the difference, a respective charging indicator that reflects the direction of the change.

2. The method of claim 1, further comprising:
determining the first power pack capacity by receiving a first power pack capacity value from a Coulomb counting power pack capacity monitor (212) at the first time; and
determining the second power pack capacity by receiving the second power pack capacity value from the Coulomb counting power pack capacity monitor at the second time, and
the estimating the difference comprising subtracting the first power pack capacity value from the second power pack capacity value, or
receiving (402) a power pack first voltage value at the first time; and
receiving (406) a power pack second voltage value at the second time, and
the difference between the first power pack capacity of the power pack and the second power pack capacity of the power pack being based upon a difference between power pack first voltage value and the power pack second voltage value, or
wherein the estimating a difference between the first power pack capacity of the power pack and the second power pack capacity of the power pack comprises estimating a net charging current (504, 506, 508, 510, 512, 514) delivered to the power pack during the time duration, and
wherein the difference between the first power pack capacity of the power pack and the second power pack capacity of the power pack is based upon the net charging current delivered to the power pack during the time duration.

3. The method of any one of claims 1 or 2, further comprising:
providing (210, 310) charging current to the power pack;
determining (216, 230, 316, 330), that a temperature of the power pack exceeds a threshold within the time duration;
halting (210), in response to determining that the temperature of the power pack exceeds the threshold within the time duration, providing the charging current; and
halting (216) the estimating the difference and the displaying in response to determining that the temperature of the power pack does not exceed the threshold within the time duration, or
changing (216), in response to the second power pack capacity being less than the first power pack capacity, an operating mode of an electronic circuit to reduce power consumption from the power pack.

4. An apparatus for determining a charging state, the apparatus comprising:
a power pack capacity monitor (212, 312, 318) configured to provide a series of power pack capacity monitoring values;
a display (218, 322) selectively presenting a charging indicator; and
a processor (216), communicatively coupled to the power pack capacity monitor and to the display, the processor configured to:
receive (402, 406), from the power pack capacity monitor, at least one power pack capacity monitoring value;
determine (408), based on the at least one power pack capacity monitoring value, a difference between a first power pack capacity at a first time and a second power pack capacity at a second time, the second time being a time duration after the first time; and
cause (412, 416) the display to present the charging indicator in response to the difference indicating the first power pack capacity is less than the second power pack capacity.

5. The apparatus of claim 4, the power pack capacity monitor comprising a Coulomb counting power pack capacity monitor (212),
the at least one power pack capacity monitoring value comprising a first power pack capacity value received from the Coulomb counting power pack capacity monitor indicating a power pack capacity at the first time,
the at least one power pack capacity monitoring value further comprising a second power pack capacity value received from the Coulomb counting power pack capacity monitor indicating a power pack capacity at the second time, and
the processor determining the difference based on a difference between the first power pack capacity and the second power pack capacity, or
the power pack capacity monitor comprising a power pack voltmeter (318) configured to measure a present power pack output voltage,
the at least one power pack capacity monitoring value comprising a first power pack output voltage value received from the power pack voltmeter indicating a power pack output voltage at the first time,
the at least one power pack capacity monitoring value further comprising a second power pack output voltage value received from the power pack voltmeter indicating a power pack output voltage at the second time, and
the processor determining the difference based on a difference between the first power pack output voltage value and the second power pack output voltage value, or
the power pack capacity monitor comprising a power pack current meter (312) configured to estimate a value of net charging current delivered to the power pack during the time duration and to provide the value, and
wherein the difference between the first power pack capacity of the power pack and the second power pack capacity of the power pack is based upon the value, or
the power pack capacity monitor comprising the power pack current meter configured to provide values of measured current delivered to the power pack and values of measured current drawn from the power pack during the time duration,
the at least one power pack capacity monitoring value comprising a plurality of measured current values obtained power pack current monitor during the time duration, and
the determining the difference between the first power pack capacity of the power pack and the second power pack capacity of the power pack comprising estimating a net charging current delivered to the power pack during the time duration based upon the plurality of measured current values,
wherein the difference between the first power pack capacity of the power pack and the second power pack capacity of the power pack is based upon the net charging current delivered to the power pack during the time duration.

6. The apparatus of any of claims 4 or 5, further comprising:
a power pack charging controller (210, 310) controlling charging current provided to the power pack;
a power pack temperature monitor (230, 330) measuring a temperature of the power pack,
the processor further communicatively coupled to the power pack charging circuit, the processor further configure to:
determine that the temperature of the power pack exceeds a threshold within the time duration;
cause the power pack charging controller to halt, in response to determining that the temperature of the power pack exceeds the threshold within the time duration, providing the charging current; and
cause the display to not present the charging indicator in response to determining that the temperature of the power pack exceeds the threshold within the time duration, or
wherein the processor is further configured to change, in response to the second power pack capacity being less than the first power pack capacity, an operating mode of an electronic circuit to reduce power consumption by the electronic circuit from the power pack.

7. A computer program for instructing a computer to perform the method of any one of claims 1, 2, or 3.

8. A power supply circuit (202, 302) that determines determining a charging state, the power supply circuit comprising:
a power pack (214, 314);
a power pack capacity monitor (212, 312), communicatively coupled to the power pack, the power pack capacity monitor configured to provide a series of power pack capacity monitoring values;
a display (322) selectively presenting a charging indicator; and
a processor (216, 316), communicatively coupled to the power pack capacity monitor and to the display, the processor configured to:
receive (402, 403, 404, 406), from the power pack capacity monitor, at least one power pack capacity monitoring value;
determine (408), based on the at least one power pack capacity monitoring value, a difference between a first power pack capacity at a first time and a second power pack capacity at a second time, the second time being a time duration after the first time; and
cause (412, 416) the display to present the charging indicator in response to the difference indicating the first power pack capacity is less than the second power pack capacity.

9. The power supply circuit of claim 8, further comprising a charging controller (210, 310) electrically coupled to the power pack.

10. A portable electronic device that determines a charging state, the portable electronic device comprising:
an operating circuit (220, 320);
a power pack (214, 314);
a charging controller (210, 310);
a power pack capacity monitor (212, 312, 318) configured to provide a series of power pack capacity monitoring values;
a display (322) selectively presenting a charging indicator; and
a processor (216, 316), communicatively coupled to the power pack capacity monitor and to the display, the processor configured to:
receive, from the power pack capacity monitor, at least one power pack capacity monitoring value;
determine, based on the at least one power pack capacity monitoring value, a difference between a first power pack capacity at a first time and a second power pack capacity at a second time, the second time being a time duration after the first time; and
cause the display to present the charging indicator in response to the difference indicating the first power pack capacity is less than the second power pack capacity.

11. The portable electronic device of claim 10, further comprising a housing (102) containing the operating circuit, the charging controller, the power pack, and the processor.
